# EUROPEAN PATENT APPLICATION

(11) **EP 2 432 309 A2**
(43) Date of publication of application: **21.03.2012**
(21) Application number: 11178332.0
(22) Date of filing: 22.08.2011
(51) Int. Cl.: H05K 13/04

(54) **Component mounting apparatus**

(30) Priority: 21.09.2010 JP 2010210353
(71) Applicant: Hitachi High-Tech Instruments Company, Ltd., Kumagaya-shi Saitama 360-0238 (JP)
(72) Inventor: Takahira, Isao, Tokyo, 100-8220 (JP); Ieizumi, Kazuyoshi, Saitama, 360-0238 (JP); Kashitani, Hisayoshi, Saitama, 360-0238 (JP); Oyama, Kazuyoshi, Saitama, 360-0238 (JP); Usui, Yoshinao, Saitama, 360-0238 (JP)
(74) Representative: Beetz & Partner

(57) **Abstract**

A component mounting apparatus (1000) for mounting components on a substrate (123) includes: a substrate mounting unit (201) on which the substrate is mounted; a first beam (101) arranged in a direction vertical to a substrate carrying direction (10); a second beam (102) arranged on a more front side than the first beam in the carrying direction; an actuator (107) arranged at the first beam; an actuator (108) arranged at the second beam; a third beam (103) connected to the actuator (107); a fourth beam (104) connected to the actuator (108); an actuator (109) arranged at the third beam; an actuator (110) arranged at the fourth beam; a component mounting unit (113) for mounting a first component of the components on the substrate connected to the actuator (109); and a component mounting unit (114) for mounting a second component of the components on the substrate connected to the actuator (110).

## Description

### BACKGROUND OF THE INVENTION

### 1. FIELD OF THE INVENTION

The present invention relates to a component mounting apparatus, and for example, relates to the apparatus for sucking an electronic component and mounting the component on a substrate.

### 2. DESCRIPTION OF THE RELATED ART

A component mounting apparatus is, for example, an apparatus for mounting various electronic components on an electronic substrate used in an electronic instrument.

As a conventional technology, Japanese Patent Laid-Open Publication No. 2010-56442 can be cited.

According to the Japanese Patent Laid-Open Publication No. 2010-56442, firstly, a component at a near area of an area bisected into a far area and the near area in relation to a distance between each one wafer ring and the other wafer ring is removed; and when the component at the near area which is an inside-half area is finished in being removed, a wafer table is clockwise turned by 180 degrees angle, and a component at an initial outside-half area is positioned near the inside, and the component is removed.

However, according to the Japanese Patent Laid-Open Publication No. 2010-56442, although two beams are disclosed, for example, when a component is mounted on a middle of a substrate, one beam has to wait while the other beam is mounting a component, and it is not considered that productivity is reduced.

A purpose of the present invention is to provide a component mounting apparatus high in productivity.

### SUMMARY OF THE INVENTION

The present invention possesses the following features:
(1) A feature of the invention exists in independently driving a plurality of heads.
(2) A feature of the invention exists in providing the plurality of heads having loading mechanisms, respectively.
(3) A feature of the invention exists in saving weight of beams, a frame, and actuator components such as a rotor of a motor in the component mounting apparatus.
(4) A feature of the invention exists in that the component mounting apparatus for mounting components on a substrate comprises: a substrate mounting unit on which the substrate is mounted; a first beam arranged in a direction vertical to a substrate carrying direction; a second beam arranged behind the first beam; a first actuator unit arranged at the first beam; a second actuator unit arranged at the second beam; a third beam connected to the first actuator unit; a fourth beam connected to the second actuator unit; a third actuator unit arranged at the third beam; a fourth actuator unit arranged at the fourth beam; a first component mounting unit configured to mount the components on the substrate connected to the third actuator unit; and a second component mounting unit configured to mount the components on the substrate connected to the fourth actuator unit.
(5) A feature of the invention exists in that the component mounting apparatus further comprises: a fifth beam connected to the first actuator unit; a third component mounting unit configured to mount the components on the substrate connected to the fifth beam; a sixth beam connected to the second actuator unit; and a fourth component mounting unit configured to mount the components on the substrate connected to the sixth beam.
(6) A feature of the invention exists in that in the component mounting apparatus at least one of the first to fourth component mounting units is connected to the loading mechanism.
(7) A feature of the invention exists in that in the component mounting apparatus the loading mechanism drives at least one of the first to fourth component mounting units in a direction parallel to the substrate carrying direction.
(8) A feature of the invention exists in that in the component mounting apparatus at least one of the first to fourth component mounting units comprises: nozzles configured to suck the components; a motor configured to rotate the nozzles; and a frame composed of the first material lighter than aluminum for supporting the nozzles and the motor.
(9) A feature of the invention exists in that in the component mounting apparatus the first material is magnesium.
(10) A feature of the invention exists in that in the component mounting apparatus at least one of the first to fourth component mounting units comprises: nozzles configured to suck the components; a motor configured to rotate the nozzles; and a frame composed of the first material lighter than aluminum for supporting the nozzles and the motor, and that the motor comprises a rotor composed of a second material lighter than aluminum.
(11) A feature of the invention exists in that in the component mounting apparatus the second material is magnesium.
(12) A feature of the invention exists in that in the component mounting apparatus at least one of the first beam and the second beam is composed of a third material lighter than aluminum.
(13) A feature of the invention exists in that in the component mounting apparatus the third material is carbon FRP (Fiber Reinforced Plastic) or magnesium.
(14) A feature of the invention exists in that in the component mounting apparatus the fifth actuator unit and the sixth actuator unit both configured to drive the first beam are provided at both longitudinal ends of the first beam, respectively.
(15) A feature of the invention exists in that in the component mounting apparatus the seventh actuator unit and the eighth actuator unit both configured to drive the second beam are provided at both longitudinal ends of the second beam, respectively.

The present invention brings the following effects. The invention may bring the following effects independently or in combination.
(1) It is possible to provide the component mounting apparatus high in productivity.
(2) It is possible to mount components even when an area where the components cannot be mounted.
(3) A positioning accuracy is improved in mounting the components.
(4) It is possible to reduce a vibration.
(5) It is possible to reduce electric power consumption.

### BRIEF DESCRIPTION OF THE DRAWINGS

FIG. 1 is a plan view of a component mounting apparatus of examples 1 and 5 according to the present invention.
FIG. 2 is a section view of the component mounting apparatus of the examples 1 and 5, and seen along a line V-V in a direction indicated by arrows in FIG. 1.
FIG. 3 is a flowchart of mounting electronic components on a substrate by any component mounting apparatus of the examples 1 to 6 according to the invention.
FIG. 4 is a drawing illustrating a component-mounting impossible area of the component mounting apparatus in the example 2.
FIG. 5 is a view seen along a line VI-VI in a direction indicated by arrows in FIG. 4 and illustrating a loading mechanism of the component mounting apparatus in the example 2.
FIG. 6 is a side view of a head of the component mounting apparatus in the example 3.
FIG. 7 is a section view of a motor of the head in the example 4.
FIG. 8 is a plan view of the component mounting apparatus of the example 6.
FIG. 9 is a section view of the component mounting apparatus of the example 6, seen along a line VII-VII in a direction indicated by arrows in FIG. 8, and illustrating an arrangement relationship between an actuator and a component supply unit.

### BEST MODE(S) FOR CARRYING OUT THE INVENTION

Here will be described the present invention with reference to drawings.

### [Example 1]

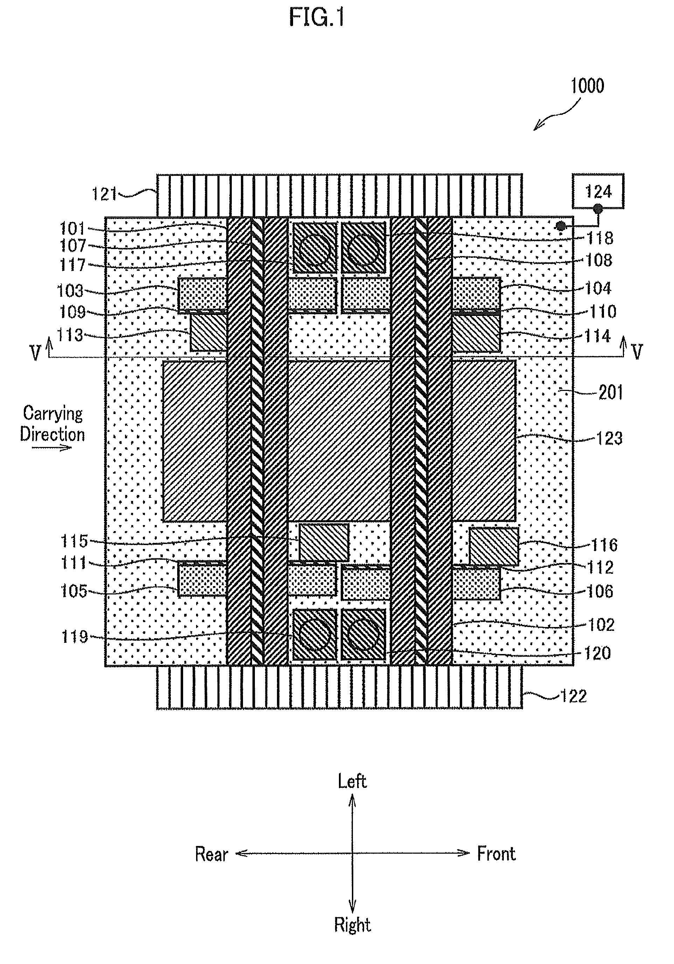

FIG. 1 is a plan view of a component mounting apparatus 1000 of an example 1 according to the present invention.

A substrate 123 is carried by a guide (not shown) in a direction shown in FIG. 1 to an electric component mounting position.

In a direction orthogonal to the direction in carrying the substrate 123 (hereinafter referred to as "substrate carrying direction") and above the substrate 123 thereof are arranged a first Y beam 101 and a second Y beam 102.

On the first Y beam 101 and the second Y beam 102 are respectively arranged X beams 103 and 105, and X beams 104 and 106.

The X beams 103 and 105, and 104 and 106 are respectively moved in the direction orthogonal to the substrate carrying direction by actuators 107, 108 of such a linear motor which are an example of an actuator unit respectively arranged at the Y beams 101, 102.

At the X beams 103, 104, 105, and 106 are arranged actuators 109, 110, 111, and 112 of such a linear motor, respectively. Then, at the actuators 109, 110, 111, and 112 are arranged heads 113, 114, 115, and 116 by which electronic components are mounted on the substrate 123. Here, it is possible to make a cheap and lightweight configuration if not a linear motor but a mechanism such as a ball screw is used as the actuators 109, 110, 111, and 112.

Then, the heads 113, 114, 115, and 116 are driven in the direction orthogonal to the Y beams 101, 102 (direction horizontal to the substrate-carrying direction) by the actuators 109, 110, 111, and 112, respectively.

Component supply units 121, 122 configured to supply electronic components to the heads 113, 114, 115, and 116 are arranged at both longitudinal ends of the first Y beam 101 and the second Y beam 102.

Then, in such a case of there being no electronic component to be mounted, the X beams 103, 104 are moved to a near side (or upward) of the component supply unit 122 by the actuators 107, 108; and moreover, by the actuators 109, 110, the heads 113, 114 are moved in an optional direction and supply electronic components to themselves from the component supply unit 121.

Moreover, by the actuators 107, 108, the X beams 105, 106 are moved to a near side (or above an upper side) of the component supply units 122, and moreover, by the actuators 111, 112, the heads 115, 116 are moved to an optional direction and supply electronic components to themselves.

Then, in the component mounting apparatus 1000, cameras 117, 118, 119, and 120 for checking postures of electronic components are arranged between the first Y beam 101 and the second Y beam 102; the postures of the supplied electronic components are checked by each of the cameras 117, 118, 119, and 120.

If inclinations of the electronic components are detected in the postures, the heads 113, 114, 115, and 116 adjust the inclinations. In addition, if the cameras 117, 118, 119, and 120 are positioned as mentioned above, when the electronic components are mounted in the vicinity of a center of the substrate 123, movement distances of the heads 113, 114, 115, and 116 are shortest; therefore, the positions are suitable.

Furthermore, a control of operations corresponding to the above is performed by a control unit 124.

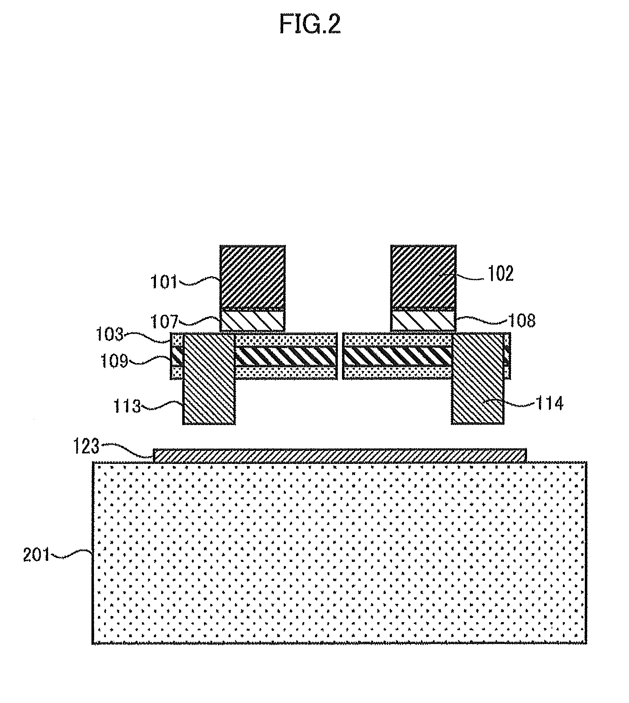

FIG. 2 is a section view of the component mounting apparatus 1000 of the examples 1 and 5, and seen along a line V-V in FIG. 1.

Here, although a portion on the periphery of the first Y beam 101 will be described in detail, this description of the second Y beam 102 is similar to that of the first Y beam 101.

Below the first Y beam 101 is arranged the actuator 107; to the actuator 107 is connected the X beam 103 so as to be universally movable in the direction orthogonal to the substrate carrying direction on a loading space 201.

In a normal direction of the substrate 123 is arranged the actuator 109; to the actuator 109 is connected the head 113 so as to be universally movable in a direction parallel to the substrate carrying direction.

As shown in FIGS. 1 and 2, in the example 1 a plurality of the heads are movable independently in the orthogonal direction and the parallel direction with respect to the substrate carrying direction. Thereby, it is possible to solve a problem that, in a conventional technology, while one beam is mounting a component, the other beam has to wait, and productivity is reduced; and to configure a high-speed component mounting apparatus 1000 faster than conventional one.

In addition, in FIG. 1, although a case of the four X beams has been described, the number of X beams may not be four. Furthermore, the direction in which the Y beams are arranged may also be parallel to the substrate carrying direction.

Furthermore, each of the X beams 103, 104, 105, and 106 may also be adapted to be detachable. In that case, it is also possible to connect different kinds of heads and achieve to mount more diverse electronic components.

### [Example 2]

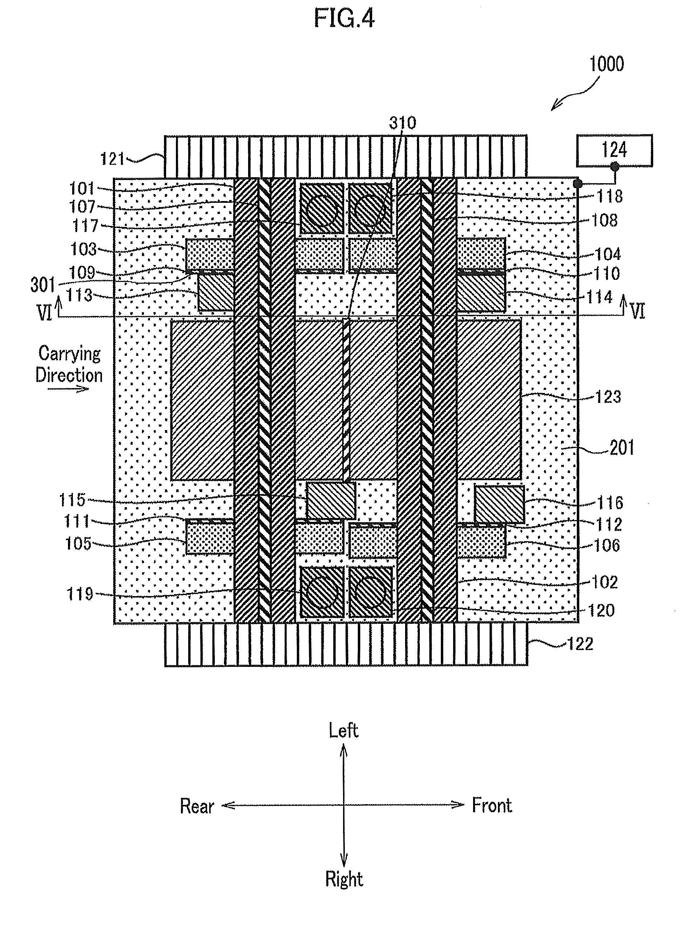

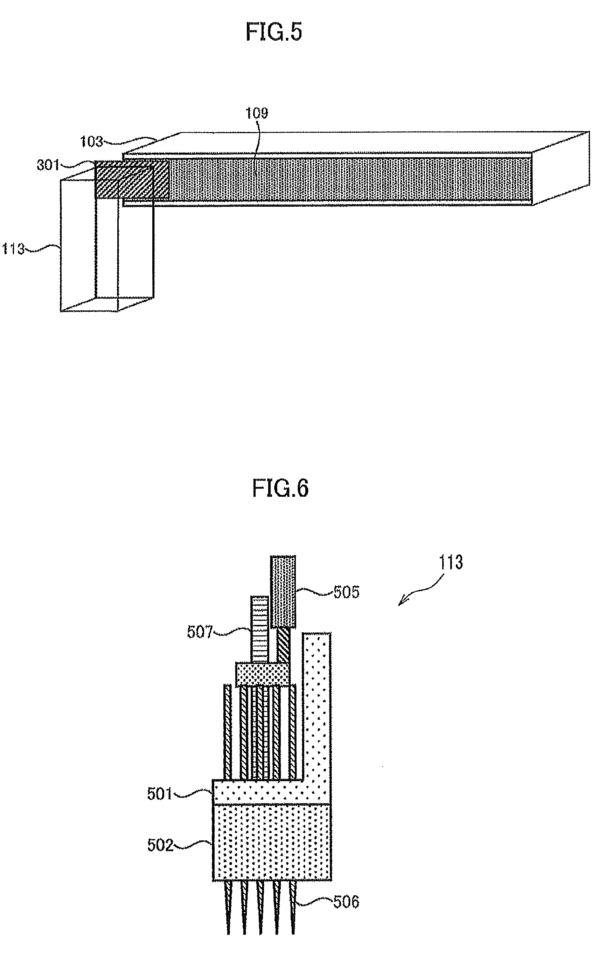

Next will be described an example 2 with reference to FIGS. 4 and 5.

For example, in a case shown in FIG. 4, an area exceeding a range where the actuator 109 can drive the head 113 may be formed in some cases at an area sandwiched by the two X beams 103, 104: that is, the area exceeding the range is an area 310 (hereinafter referred to as a "component-mounting impossible area 310") where electronic components cannot be mounted.

Consequently, the example 2 will be described with reference to FIGS. 4 and 5, wherein it is possible to mount the electronic components even when the component-mounting impossible area 310 is formed.

In the example 2 the head 113 of the X beam 103 is provided with a loading mechanism 301 movable onto the component-mounting impossible area 310. Hereafter will be described the loading mechanism 301.

A schematic drawing of the loading mechanism 301 is shown in FIG. 5. For example, the loading mechanism 301 further extends a distance, where the actuator 109 can drive the head 113, and drives the head 113 in the direction parallel to the substrate carrying direction.

The loading mechanism 301 is a slide mechanism specifically arranged at the actuator 109 of the X beam 103 and driven by a pulse voltage and the like; according to the example 2, the head 113 is driven through the mechanism 301.

The control unit 124 determines the following matters, for example, based on substrate positioning data, design data (for example, CAD (Computer Aided Design) data and the like), an X beam movement distance, and the like:
(1) Whether or not the component-mounting impossible area 310 is formed; and
(2) Whether or not an area where an electronic component should be mounted exists in the component-mounting impossible area 310.

When the control unit 124 determines that the component-mounting impossible area 310 is formed and an area where an electronic component should be mounted exists in the component-mounting impossible area 310, the component mounting apparatus 1000 of the example 2 performs the following operations:
(1) The head 113 is driven by the actuator 109 to a distance where the actuator 109 can drive the head 113; and
(2) Regarding the component-mounting impossible area 310, the head 113 is moved by applying a pulse voltage corresponding to the distance toward the area where the electronic component should be mounted on the loading mechanism 301.

According to the example 2, even when the component-mounting impossible area 310 is formed, it is possible to mount the electronic component.

In addition, the loading mechanism 301 of the example 2 is not limited to a slide mechanism, and an application thereof is not limited to that for mounting an electronic component on the component-mounting impossible area 310. It may also be available to perform such a control of the X beam 103 roughly moving and the loading mechanism 301 minutely moving.

### [Example 3]

Next will be described an example 3 with reference to FIG. 6.

For example, in the case of FIG. 1, a number of parts of the component mounting apparatus 1000 above the substrate 123 results in more than that of a conventional component mounting apparatus in some cases.

Therefore, weight of an upper portion of the component mounting apparatus 1000 increases in some cases. A vibration of the component mounting apparatus 1000 tends to occur when the weight of the upper portion of the apparatus 1000 increases.

In the example 3 will be described an example considering the vibration.

That is, in the example 3 will be described weight saving of an upper portion of the component mounting apparatus 1000. It is possible to suppress the vibration by performing the weight saving.

In the example 3 will be described the weight saving of the head 113.

FIG. 6 is a side view of the head 113. The head 113 is configured with an exhaust center shaft 507, nozzles 506 for vacuum-sucking an electronic component, a motor 505 for moving the nozzles 506 up and down, a motor 502 for rotating the nozzles 506, further a frame 501 for supporting those, and a motor not shown and for appropriately selecting any of the nozzles 506, and the like.

Although the frame 501 is conventionally made of aluminum, in the example 3 the frame 501 is made of magnesium which is an example of a material lighter than the aluminum.

Because the magnesium is lighter than the aluminum and can ensure strength to the degree of the strength not influencing to mount an electronic component, the magnesium is suitable for the material of the frame 501 located near the component mounting position compared to other parts, wherein therefore a rigidity is required for the material of the frame 501. Moreover, the magnesium is also suitable for the material of the frame 501 in cutting ability and cost.

Thus, it is possible to bring the following effects by configuring the frame 501, for example, with magnesium:
(1) It is possible to suppress the vibration of the component mounting apparatus 1000 from occurring because parts weight of the upper portion of the apparatus is made to be light; and
(2) Because the head 113 for mounting the electronic component is made to be light, and it is thereby possible to reduce an influence of an inertia accompanied with the movements of the head 113, it is possible to improve a positioning accuracy in mounting the component and to furthermore achieve speeding up.

### [Example 4]

Next, as an example 4, will be described a case where the motor 502 for rotating the nozzles 506 configuring the head 113 is weight-saved.

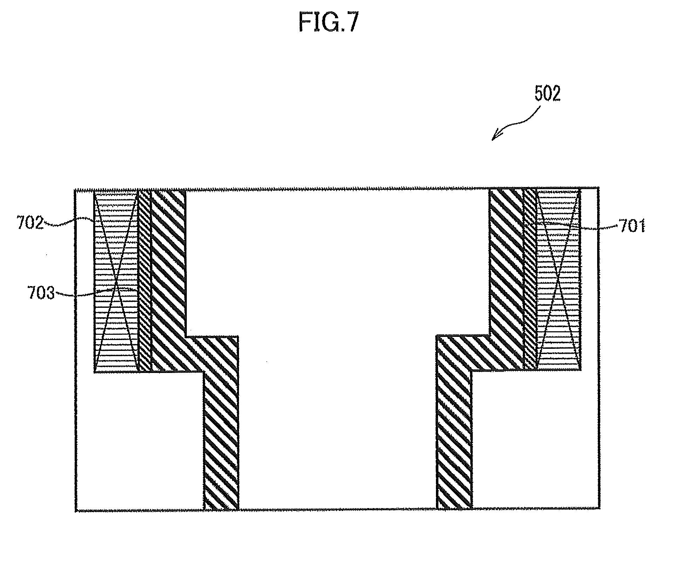

FIG. 7 is a section view of the motor 502. The motor 502 has a hollow structure so that the nozzles 506 are inserted, and around the hollow structure is arranged a rotor 701. Moreover, around the rotor 701 is arranged a magnetic body 703. Then, around the magnetic body 703 is arranged a coil 702.

Although a rotor is conventionally composed of aluminum, in the example 4 the rotor 701 is composed of magnesium.

The magnesium is lighter than the aluminum. Moreover, the magnesium is excellent in cutting ability and cost. Therefore, the magnesium is suitable for a material of the rotor 701.

Thus, by saving the weight of the rotor 701, it is possible to bring the following effects:
(1) Because the rotor 701 itself is weight-saved, it is possible to reduce required torque. Therefore, it is possible to reduce a winding number of the coil 702. Consequently, it is possible to further achieve saving weight. Because the coil 702 is usually composed of copper, the effect of saving the weight of the coil 702 is extremely big.
(2) Furthermore, because the rotor 701 is weight-saved, even when the rotor 701 rotates like a conventional rotor, the rotor 701 can be operated by electric power less than by that of the conventional rotor; therefore, low consumption electric power is expected to be achieved.

In addition, in the examples 3 and 4, the magnesium has been described as an example, the material of the rotor 701 may also be, for example, composed of a single element or a composite material. Naturally, as a way of saving weight, it is also available to save the weight by focusing on the structure of the rotor 701 other than focusing on the material thereof.

### [Example 5]

Next will be described another example of saving weight as an example 5.

In the example 5 at least one of the X beams 103, 104, 105, and 106, and Y beams 101, 102 of the example 1 is weight-saved,

Specifically, at least one of the X beams 103, 104, 105, and 106, and Y beams 101, 102 of the example 1 is composed of carbon FRP which is an example of a material lighter than aluminum.

According to the example 5, it is possible to save the weight of the beams whose weight is relatively large compared to other drive members. Thus, it is possible to widely reduce the vibration and to further achieve speeding up.

In addition, although in the example 5 the carbon FRP has been described as an example, for example, the magnesium is also available, and other materials are also available if they are light.

### [Example 6]

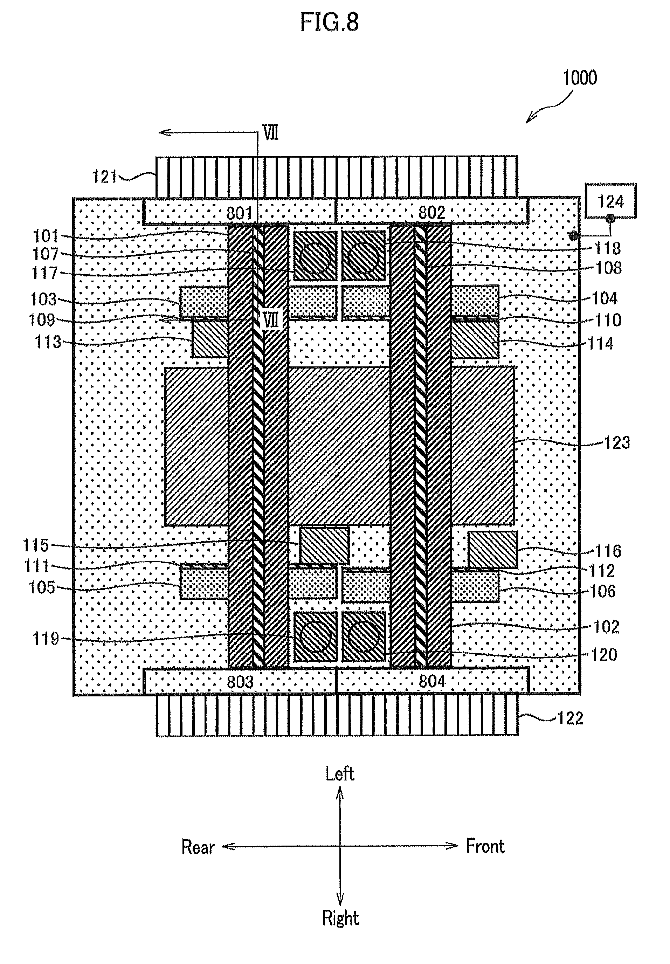

Next will be described another example as an example 6 with reference to FIG. 8.

As shown in FIG. 8, the Y beam 101 is provided with actuators 801,803; the Y beam 102 is provided with actuators 802, 804. In the example 6 at least one of the Y beams 101, 102 of the example 1 is provided with respective actuators of actuators 801,803, and 802, 804.

The actuators 801, 803 are configured to move the Y beam 101 in the direction parallel to the substrate carrying direction and are respectively arranged at both longitudinal ends of the Y beam 101.

Furthermore, the actuators 802, 804 are configured to move the Y beam 102 in the direction parallel to the substrate carrying direction and are respectively arranged at both longitudinal ends of the Y beam 102.

According to the example 6, because the Y beams 101, 102 are independently driven, the actuators 801 and 803, and the actuators 802 and 804 are configured to be independent.

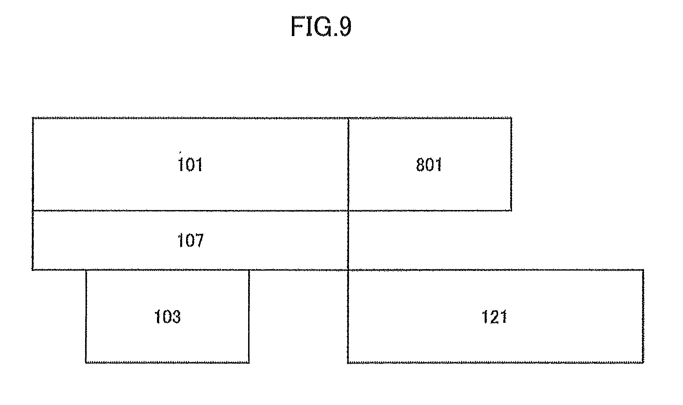

FIG. 9 is a section view of the component mounting apparatus 1000 of the example 6, seen along a line VII-VII in FIG. 8, and illustrating a structure in the vicinity of the actuator 801.

As shown in FIGS. 8 and 9, the actuators 801, 802, 803, and 804 are configured to be arranged at positions higher than the component supply units 121, 122 and to drive the Y beams 101, 102 so that the heads 113, 114, 115, and 116 can supply electronic components to themselves at the component supply units 121, 122, respectively,

According to the example 6, it is possible to make a degree of freedom higher in mounting the electronic components and to do away with an area such as the component-mounting impossible area 310.

In addition, although the idea of the example 6 is also applicable to an existing component mounting apparatus, the idea is more suitable for the component mounting apparatus 1000 whose heads, motors, and beams exemplified in the examples 3 to 5 are weight-saved.

### [Process of Mounting Electronic Components]

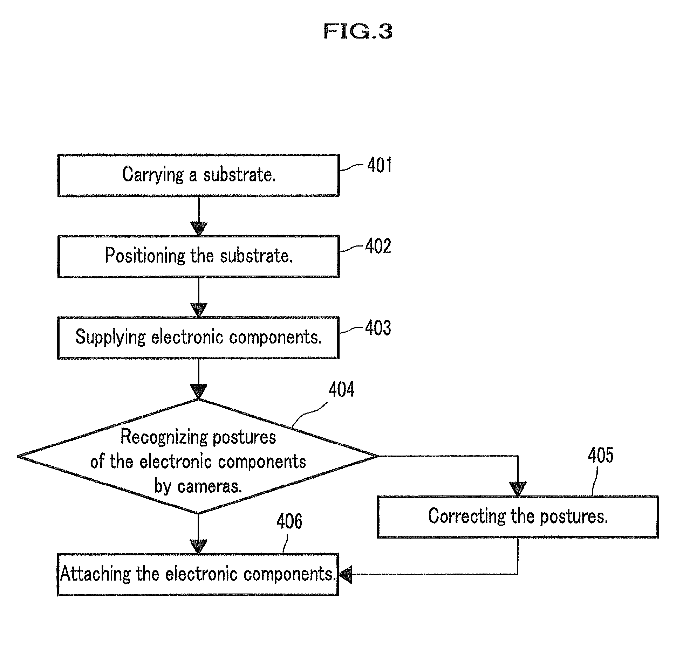

FIG. 3 is a flowchart of mounting electronic components on the substrate 123 by the component mounting apparatus 1000 of the examples 1 to 6.

Firstly, the substrate 123 is carried to an electronic component mounting position (401).

Next, the substrate 123 is positioned (402).

The X beams 103, 104, 105, and 106 are independently moved to the component supply units 121, 122 and supply electronic components, which are to be mounted on the substrate 123, to themselves, respectively (403).

The heads 113, 114, 115, and 116 suck the electronic components from the component supply units 121, 122 and move to the substrate 123 by the actuators 107, 108 mounted on the Y beams 101, 102.

On the way of moving the substrate 123, the heads 113, 114, 115, and 116 pass by the cameras 117, 118, 119, and 120.

Each of the cameras 117, 118, 119, and 120 detects a component holding posture (a position, an angle, and the like) when each of the heads 113, 114, 115, and 116 passes by each of the cameras (404).

When the posture is inclined, it is corrected (405).

After the heads 113, 114, 115, and 116 are moved to the substrate 123, they start mounting the electronic components thereto, respectively.

The heads 113, 114, 115, and 116 mount the electronic components to the substrate 123, respectively, with being moved parallel to the substrate carrying direction by the actuators 109, 110, 111, and 112 mounted on the X beams 103, 104, 105, and 106 (406).

When mounting the electronic components is finished, the heads 113, 114, 115, and 116 are moved to the component supply units 121, 122.

The present invention is not limited to the examples 1 to 6. It is also possible to adopt each of the examples 1 to 6 independently of another of the examples 1 to 6.

## Claims

1. A component mounting apparatus (1000) for mounting components on a substrate (123) being **characterized by** comprising:
a substrate mounting unit (201) on which the substrate (123) is mounted;
a first beam (101) arranged in a direction vertical to a substrate carrying direction (10);
a second beam (102) arranged on a more front side than the first beam (101) in the substrate carrying direction (10);
a first drive unit (107) arranged at the first beam (101);
a second drive unit (108) arranged at the second beam (102);
a third beam (103) connected to the first drive unit (107);
a fourth beam (104) connected to the second drive unit (108);
a third drive unit (109) arranged at the third beam (103);
a fourth drive unit (110) arranged at the fourth beam (104);
a first component mounting unit (113) configured to mount a first component of the components on the substrate (123) connected to the third drive unit (109); and
a second component mounting unit (114) configured to mount a second component of the components on the substrate (123) connected to the fourth drive unit (110).

2. The component mounting apparatus (1000) according to claim 1 further comprising:
a fifth beam (105) connected to the first drive unit (107);
a third component mounting unit (115) configured to mount a third component of the components on the substrate (123) connected to the fifth beam (105);
a sixth beam (106) connected to the second drive unit (108); and
a fourth component mounting unit (116) configured to mount a fourth component of the components on the substrate (123) connected to the sixth beam (106).

3. The component mounting apparatus (1000) according to claim 2 further comprising a loading mechanism (301), wherein at least one of the first to fourth component mounting units (113, 114, 115, 116) is connected to the loading mechanism (301).

4. The component mounting apparatus according to claim 3, wherein the loading mechanism(301) drives at least one of the first to fourth component mounting units (113, 114, 115, 116) in a direction parallel to the substrate carrying direction (10).

5. The component mounting apparatus (1000) according to claim 2, wherein at least one of the first to fourth component mounting units (113, 114, 115, 116) comprises:
nozzles (506) configured to suck the component;
a motor (502) configured to rotates the nozzles (506); and
a frame (501) composed of a first material lighter than aluminum for supporting the nozzles (506) and the motor (502).

6. The component mounting apparatus (1000) according to claim 5, wherein the first material is magnesium.

7. The component mounting apparatus (1000) according to claim 2, wherein at least one of the first to fourth component mounting units (113, 114, 115, 116) comprises:
nozzles (506) configured to suck the component;
a motor (502) configured to rotates the nozzles (506); and
a frame (501) composed of a first material lighter than aluminum for supporting the nozzles (506) and the motor (502), and
wherein the motor (502) comprises a rotor (701) composed of a second material lighter than aluminum.

8. The component mounting apparatus (1000) according to claim 7, wherein the second material is magnesium.

9. The component mounting apparatus (1000) according to claim 1, wherein at lest one of the first beam (101) and the second beam (102) is composed of a third material lighter than aluminum.

10. The component mounting apparatus (1000) according to claim 9, wherein the third material is carbon FRP (Fiber Reinforced Plastic) or magnesium.

11. The component mounting apparatus (1000) according to claim 1 further comprising a fifth drive unit (801) and a sixth drive unit (803) configured to drive the first beam (101) and provided at both longitudinal ends of the first beam (101), respectively.

12. The component mounting apparatus (1000) according to claim 1 further comprising a seventh drive unit (802) and an eighth drive unit (804) configured to drive the second beam (102) and provided at both longitudinal ends of the second beam (102), respectively.
